# EUROPEAN PATENT APPLICATION

(11) **EP 4 750 310 A1**
(43) Date of publication of application: **27.05.2026**
(21) Application number: 25217051.9
(22) Date of filing: 19.11.2025
(51) Int. Cl.: H10W 70/685, H10W 70/692, H10W 74/10, H10W 76/18, H10W 20/20, H10W 40/77, H10W 70/63, H10W 90/00

(54) **GLASS CORE FOR PACKAGING AND METHOD OF MANUFACTURING GLASS CORE FOR PACKAGING**

(30) Priority: 22.11.2024 US 202463723599 P
(71) Applicant: Absolics Inc., Covington, GA 30014 (US)
(72) Inventor: YUN, SeHan, Covington, Georgia, 30014 (US)
(74) Representative: BCKIP Part mbB

(57) **Abstract**

Embodiments relate to a glass core for packaging, a packaging substrate, and a method of manufacturing the glass core. A glass core for packaging comprises: plate glass having first and second surfaces facing each other; through-vias penetrating the plate glass in a thickness direction; and a cavity penetrating the first and second surfaces and allowing placement of a semiconductor element therein. The cavity provides a cavity space surrounded by a cavity inner wall, which is an inner wall surface connecting the first and second surfaces of the plate glass. A die block is disposed in the cavity space; the die block has a cavity die and a glass spacer vertically stacked. A distribution material is disposed between the cavity inner wall and the die block. The embodiments alleviate thickness mismatch when embedding a die in the cavity, improve workability and reliability.

## Description

This application claims priority of U.S. Provisional Patent Application No. 63/723,599, filed on November 22, 2024.

### BACKGROUND

### TECHNICAL FIELD

Disclosed are a glass core for packaging and a method of manufacturing the glass core for packaging.

### DESCRIPTION OF RELATED ART

In manufacturing electronic components, implementing circuits on a semiconductor wafer is referred to as the front-end (FE), and assembling the wafer into a state usable in an actual product is referred to as the back-end (BE). A packaging process is included in the back-end.

Among the four core technologies of the semiconductor industry that have enabled the rapid development of electronic products are semiconductor technology, semiconductor packaging technology, manufacturing process technology, and software technology.

Semiconductor technology has advanced in various forms, such as sub-micrometer and nanometer line widths, cells numbering in the tens of millions, high-speed operation, and high heat dissipation. However, technologies for perfectly packaging such semiconductors have relatively lagged behind.

Accordingly, the electrical performance of a semiconductor is sometimes determined more by packaging technology and the resulting electrical interconnections than by the semiconductor technology itself.

As materials for a packaging substrate, ceramics or resins are applied. In the case of a ceramic substrate such as a silicon substrate, it is not easy to mount high-performance, high-frequency semiconductor elements due to high resistivity or high dielectric constant. A resin substrate can relatively allow mounting of high-performance, high-frequency semiconductor elements; however, there are limits to reducing wiring pitch.

Recently, silicon or glass can be applied as high-end packaging substrates. By forming through-holes in a silicon or glass substrate and applying an electrically conductive material to the through-holes, the wiring length between an element and a motherboard can be shortened and excellent electrical characteristics can be achieved.

Related art includes Korean Patent No. 10-2499039, Korean Patent No. 10-1925372, and Korean Patent No. 10-2580122.

### SUMMARY

In some embodiments, a glass core for packaging that improves workability and reliability by alleviating thickness differences when embedding dies in a cavity of the glass core is provided.

In some embodiments, a glass core for packaging and a packaging substrate that may reduce a height difference between a die embedded in a cavity and a surface of the glass core, thereby enabling a redistribution layer to be formed more efficiently are provided.

In some embodiments, a glass core for packaging, a packaging substrate, and a method of manufacturing the same, which are useful for semiconductor packaging and, by applying a glass core, exhibit excellent insulating properties distinguishable from wafers and fine wiring resolution distinguishable from prepregs are provided.

According to the embodiments, a glass core for packaging according comprises: a plate glass having a first surface and a second surface facing each other; through-vias penetrating the plate glass in a thickness direction; and a cavity that penetrates the first surface and the second surface and allows a semiconductor element to be disposed therein is provided.

The cavity provides a cavity space surrounded by a cavity inner wall.

The cavity inner wall is an inner wall surface of the plate glass that connects the first surface and the second surface of the plate glass.

A die block is disposed in the cavity space.

The die block may have, stacked in the vertical direction within the cavity, a cavity die that is a die disposed in the cavity and a glass spacer.

A distribution material may be disposed between the cavity inner wall and the die block.

The die block may further include a die adhesive layer as an adhesive layer.

The die adhesive layer may be disposed between the cavity die and the glass spacer.

A thickness of the cavity die may be 90% or less of a thickness of the plate glass.

The die block has a first face and a second face facing each other, and one of (i) the first surface of the plate glass and the first face of the die block, or (ii) the second surface of the plate glass and the second face of the die block, may be disposed substantially coplanar.

The cavity die has a first face in contact with the glass spacer and a second face opposite to the first face, and an electrode of the cavity die may be disposed on the second face of the cavity die.

A cavity redistribution line may further be disposed on one face or the other face of the cavity die, and the cavity redistribution line may be a redistribution line that delivers an electrical signal of the cavity die to outside the cavity.

A thickness of the glass spacer may be 10% or more of the thickness of the plate glass.

The die block may have a thickness (Td) of 40 µm or more between an upper face of the cavity die and a lower face of the glass spacer.

Through-electrodes may be disposed in the through-vias.

The through-electrodes deliver electrical signals between the first surface and the second surface of the plate glass.

The through-electrodes may have through-electrode pads that are pads disposed on at least one of the first surface and the second surface of the plate glass.

A pad disposed at one end of an electrode of the cavity die is a cavity-die electrode pad.

With reference to a surface of the through-electrode pad, a surface of the cavity-die electrode pad may be disposed within a range of -100 µm to +100 µm in the thickness direction of the glass core.

According to the embodiments, a packaging substrate includes: the glass core for packaging described above; and an upper redistribution layer disposed over the glass core for packaging is provided.

The upper redistribution layer includes an upper electrically conductive layer and an upper insulating layer.

The upper electrically conductive layer is a layer in which electrically conductive material forms and connects in a pattern, and the upper insulating layer has the upper electrically conductive layer disposed therein.

According to the embodiments, a method of manufacturing the glass core for packaging, includes: a placing operation of disposing, on a carrier, the plate glass in which a cavity is arranged and a die block to obtain an assembly; a dispensing operation of disposing a distribution material between the cavity inner wall of the assembly and the die block to prepare a fixed body; and a fixing operation of removing the carrier from the fixed body to obtain the glass core for packaging is provided.

The carrier may detachably fix positions of the plate glass and the die block.

The plate glass is a plate-shaped glass having the first surface and the second surface facing each other; the cavity and the through-vias are arranged in the plate glass; the through-vias penetrate the plate glass in the thickness direction; and the cavity provides the cavity space surrounded by the cavity inner wall.

The cavity inner wall is an inner wall surface, as seen from the cavity toward one surface of the plate glass, that connects the first surface and the second surface of the plate glass, and the cavity space allows placement of a cavity die. The cavity die is a die disposed in the cavity.

The die block has the cavity die and the glass spacer stacked in the vertical direction.

The carrier may comprise a support layer and an adhesive layer disposed on the support layer.

The adhesive layer may be one whose adhesive force changes upon irradiation with ultraviolet light.

The die block may be prepared by a die-block manufacturing operation.

The die-block manufacturing operation includes: a die placing process of disposing one or two or more cavity dies at intervals on a spacer glass to prepare a placement material; and a die separating process of dicing the interval locations to separate the placement material and obtain the die block.

A polishing operation may be performed after the die placing operation.

The spacer glass has a first face on which the cavity dies are disposed and a second face opposite to the placement face, and the polishing process is an operation of grinding a surface of the second face of the spacer glass.

The spacer glass may have a thickness greater than 300 µm.

The glass spacer may have a thickness of 300 µm or less.

The method of manufacturing the glass core for packaging may further comprise an electrode-forming operation.

The electrode-forming operation may be performed before the placing operation or after the fixing operation.

The electrode-forming operation is an operation of forming electrodes in the through-vias to prepare the through-electrodes.

An electrode of the cavity die is an electrode disposed on one surface of the cavity die.

The glass spacer has a first face and a second face facing each other, and the second surface of the plate glass and the second face of the glass spacer may be disposed substantially in the same plane.

The electrode of the cavity die may be disposed substantially coplanar with the first surface of the plate glass, or may be disposed to protrude beyond the coplanar plane.

The dispensing operation may include: a first process of disposing a film-shaped distribution material between the assembly; a second process of allowing the distribution material to be drawn into (be embedded between) the cavity inner wall and the die block through vacuum lamination; and a third process of heat-treating the assembly at least once to induce curing of the distribution material and fix the distribution material.

In the placing operation, through-electrodes may be disposed in part of the through-vias of the plate glass, and remaining portions may be empty spaces.

Placement of the distribution material in the dispensing operation and placement of an insulating material in the empty spaces of the through-electrodes may proceed simultaneously.

The distribution material may be an organic material or an organic-inorganic composite material.

The organic material may comprise an epoxy resin or an acrylic resin.

The organic-inorganic composite material may comprise insulating particles and a binder.

The binder may comprise an epoxy resin or an acrylic resin.

### BRIEF DESCRIPTION OF THE DRAWINGS

FIG. 1 is a conceptual cross-sectional view illustrating a glass core for packaging according to an embodiment.
FIG. 2 is a conceptual cross-sectional view illustrating a glass core for packaging according to another embodiment.
FIG. 3 is a conceptual cross-sectional view illustrating a glass core for packaging according to still another embodiment.
FIG. 4 is a conceptual cross-sectional view illustrating a glass core for packaging according to yet another embodiment.
FIG. 5 is a conceptual cross-sectional view illustrating a packaging substrate according to an embodiment.
FIGS. 6A to 6C are conceptual cross-sectional views illustrating a process of manufacturing a die block according to an embodiment.
FIGS. 7A to 7E are conceptual cross-sectional views illustrating a process of manufacturing a glass core for packaging according to an embodiment.

### DESCRIPTION OF THE EMBODIMENTS

Hereinafter, embodiments will be described in detail with reference to the accompanying drawings so that those skilled in the art to which the embodiments pertain may easily carry out the invention. However, the embodiments may be implemented in various different forms and are not limited to the specific examples described herein. Throughout the drawings, like reference numerals are used to designate like parts.

Throughout the present specification, the term "and/or combinations thereof" included in a Markush-type expression means a mixture or combination of one or more selected from the group of components described in the Markush expression, and refers to inclusion of one or more selected from the group.

Throughout the specification, terms such as "first," "second," or "A," "B" are used merely to distinguish similar components from each other. Unless clearly stated otherwise, singular expressions may include plural forms.

In the present specification, the expression "~ group" may mean that the compound includes a compound corresponding to "~" or a derivative thereof.

In the present specification, the expression that "B is disposed on A" means that B is disposed directly on A or that B is disposed on A with another layer interposed therebetween, and is not limited to the case where B is in direct contact with the surface of A.

The expression that "B is connected to A" means that A and B are directly connected or connected through another component, and unless specifically mentioned otherwise, it should not be interpreted as limited to a direct connection.

A prepreg is a form in which a polymer resin is impregnated into glass fibers and has been used as a support of a packaging substrate. However, there are limits to forming fine wiring patterns with a prepreg. A silicon substrate allows formation of finer wiring and has been applied as a support of a packaging substrate. However, because silicon itself has semiconductor properties, it has a disadvantage of reduced efficiency in transmitting high-frequency signals.

The inventors applied plate glass as a support of the packaging substrate. The plate glass processed as a support of a packaging substrate is referred to as a glass core.

The glass core has various advantages as a support for a packaging substrate. Specifically, the glass core can be manufactured on a large area and enables formation of large-area vias relatively easily through etching or similar processes. In addition, even when high-frequency elements are mounted, parasitic element generation is almost negligible. However, the glass core also has disadvantages as a support for a packaging substrate. Because glass is brittle, the glass core is relatively vulnerable to impact and can easily break. This drawback becomes more pronounced as the glass core becomes thinner.

The inventors focused on the mismatch between the thickness of a die and the thickness of the glass core when the die is inserted into a cavity of the glass core, and proposed the application of a glass spacer as a means to solve this mismatch.

### Glass Core for Packaging

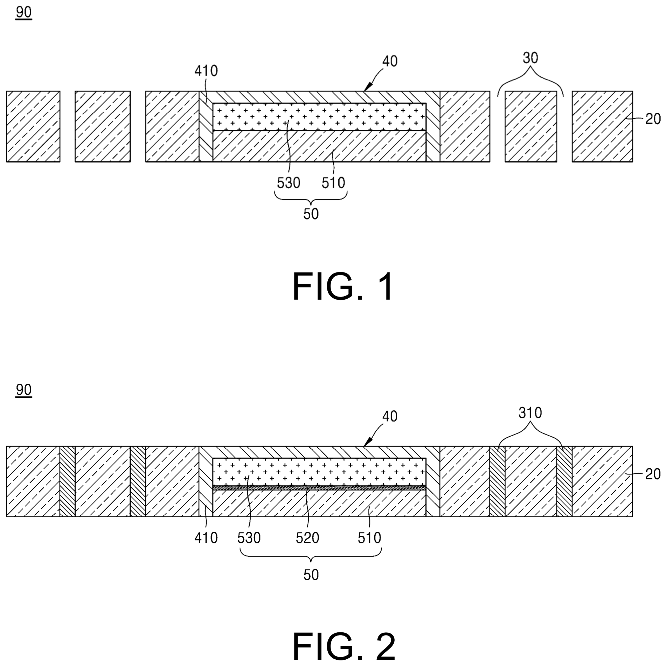

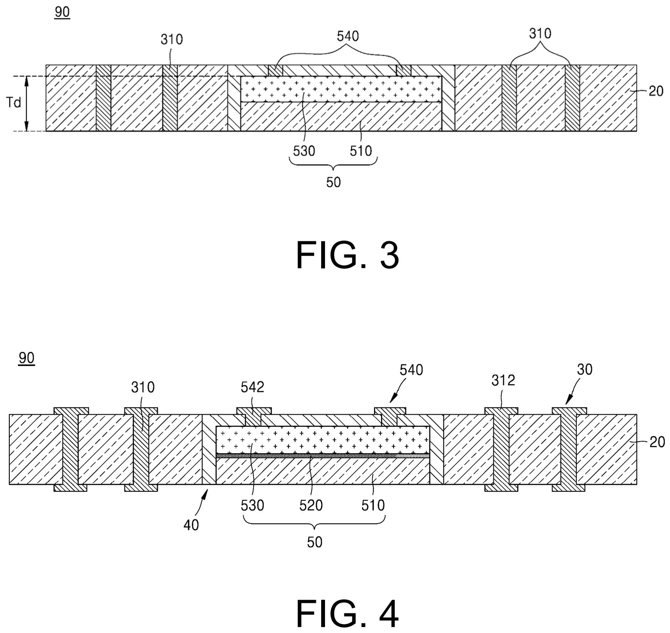

FIG. 1 is a conceptual cross-sectional view illustrating a glass core for packaging according to an embodiment; FIG. 2 is a conceptual cross-sectional view illustrating a glass core for packaging according to another embodiment; FIG. 3 is a conceptual cross-sectional view illustrating a glass core for packaging according to still another embodiment; and FIG. 4 is a conceptual cross-sectional view illustrating a glass core for packaging according to yet another embodiment. Referring to FIGS. 1 to 4, the embodiments will be described in more detail below.

A glass core for packaging 90 according to one embodiment comprises: a plate glass 20 having a first surface and a second surface facing each other; through-vias 30 penetrating the plate glass in a thickness direction; and a cavity 40 penetrating the first and the second surfaces and allowing a semiconductor element to be disposed therein.

The plate glass 20 is preferably a type applicable to semiconductor use, for example, borosilicate plate glass or alkali-free plate glass, but is not limited thereto.

The through-via 30 is a via penetrating the plate glass 20 in a thickness direction, and a plurality of through-vias 30 may be arranged in the plate glass 20.

Through-electrodes 310 may be disposed in the through-vias 30.

The through-electrodes 310 may electrically connect between the first surface and the second surface of the plate glass 20.

The through-electrodes 310 may be formed such that the through-vias 30 are entirely filled with an electrically conductive layer.

Alternatively, the through-electrodes 310 may include an electrically conductive layer disposed on an inner wall surface of the through-via 30. In this case, a portion of the through-via 30 where the electrically conductive layer of the through-electrodes 310 is not disposed may be left empty or filled with an insulating layer.

The through-electrodes 310 may have through-electrode pads 312 that are pads disposed on at least one of the first surface and the second surface of the plate glass 20.

The cavity 40 provides a cavity space surrounded by a cavity inner wall.

The cavity inner wall is an inner wall surface of the plate glass 20, as viewed from the cavity toward one surface of the plate glass 20, that connects the first surface and the second surface of the plate glass 20.

A die block 50 is disposed in the cavity space.

The die block 50 has a structure in which a cavity die 530 and a glass spacer 510 are vertically stacked.

The cavity die 530 refers to a die disposed in the cavity 40.

As an example, the cavity die 530 may be a silicon chip (Si chip).

The cavity die 530 may be, for example, a silicon-carbide chip (SiC chip).

The cavity die 530 may be, for example, a passive element. The passive element may include a capacitor or a power-transfer element.

The cavity die 530 may be, for example, an active element. The active element includes computing elements such as a CPU or a GPU, and memory elements such as a memory chip.

The die block 50 may further comprise a die adhesive layer 520 as an adhesive layer.

The die adhesive layer 520 may be disposed between the cavity die 530 and the glass spacer 510 to fix their relative positions.

The die adhesive layer may be an adhesive layer applicable to semiconductor processes, and, by way of example, a silicone adhesive layer or an acrylic adhesive layer may be used.

The die block 50 has a first face and a second face facing each other.

The first surface of the plate glass 20 and the first face of the die block 50 may be disposed substantially coplanar. In this case, the cavity die may be disposed on the second-face side of the die block 50.

The second surface of the plate glass 20 and the second face of the die block 50 may be disposed substantially coplanar. In this case (as illustrated in the drawings), the cavity die may be disposed on the first-face side of the die block.

The cavity die 530 has a first face in contact with the glass spacer 510 and a second face opposite to the first face, and an electrode 540 of the cavity die may be disposed on the second face of the cavity die 530.

A pad may be disposed at a terminal end of the electrode 540 of the cavity die. This pad is referred to as a cavity-die electrode pad 542.

The electrode 540 of the cavity die may be disposed substantially coplanar with a surface of the plate glass 20.

The electrode 540 of the cavity die may be disposed to protrude beyond the surface of the plate glass 20.

A height difference between a surface of the cavity-die electrode pad 542 and a surface of the through-electrode pad 312 may be within 100 µm. The difference may be 80 µm or less, 70 µm or less, 60 µm or less, 50 µm or less, 40 µm or less, 30 µm or less, or 20 µm or less. The difference may be 0 µm or greater, or 1 µm or greater. The expression that the difference is 0 µm means that the positions of the two surfaces are substantially the same.

Specifically, with reference to the surface of the cavity-die electrode pad 542, the surface of the through-electrode pad 312 may be disposed within a range of -100 µm to +100 µm in the thickness direction of the glass core. With reference to the surface of the cavity-die electrode pad 542, the surface of the through-electrode pad 312 may be disposed within a range of -80 µm to +80 µm in the thickness direction of the glass core. With reference to the surface of the cavity-die electrode pad 542, the surface of the through-electrode pad 312 may be disposed within a range of -70 µm to +70 µm, -60 µm to +60 µm, -50 µm to +50 µm, -40 µm to +40 µm, -30 µm to +30 µm, or -20 µm to +20 µm in the thickness direction of the glass core.

In such cases, positions of the surfaces of the electrodes of the cavity die disposed in the cavity and the through-electrodes can be controlled within a predetermined range, thereby facilitating subsequent formation of wiring layers connected thereto. Stable wiring connections are thereby enabled, which is advantageous for stable electrical signal connection.

As needed, a cavity redistribution line (not shown) may further be disposed on one face or the other face of the cavity die 530. In this case, the cavity redistribution line refers to a wiring layer formed in the cavity. Specifically, the cavity redistribution line may be a redistribution line that delivers an electrical signal of the cavity die 530 to outside the cavity.

A distribution material 410 is disposed between the cavity inner wall and the die block. The distribution material fills a space between the cavity inner wall and the die block and fixes their relative positions.

The distribution material may be, for example, an insulating material.

As the insulating material, an organic material or an organic-inorganic composite material may be applied.

The insulating material may include a polymer resin, a mixture of a polymer resin and a filler (e.g., inorganic particles, organic particles, or organic-inorganic composite particles), or an inorganic deposition layer.

The polymer resin may comprise an acrylic resin, an epoxy resin, or modified resins thereof, and materials applicable to electronic devices for purposes such as molding may be used. By way of example, a liquid crystal polymer (LCP) may be used.

The mixed material may include a mixture of an acrylic resin and a filler, a mixture of an acrylic resin and an epoxy resin with a filler, or a mixture of an epoxy resin and a filler. The filler may be inorganic particles, for example, silica particles.

As commercially available options, the distribution material may include ABF (Ajinomoto Build-up Film), EMC (Epoxy Molding Compound), MPI (Modified Polyimide), CUF (Capillary Underfill), NCF (Non-Conductive Films), or NCP (Non-Conductive Pastes).

The distribution material may be brought into a flowable state, placed within the glass core while filling the space between the cavity inner wall and the die block, and then cured. For example, the material may be fluidized by heating, placed at an appropriate position, and then thermally cured (or otherwise cured) to fix the position of the die block within the cavity inner wall.

A thickness of the cavity die 530 may be smaller than a thickness of the plate glass 20. Specifically, the thickness of the cavity die 530 may be 90% or less of the thickness of the plate glass 20. The thickness of the cavity die 530 may be 85% or less, 80% or less, 75% or less, 70% or less, 65% or less, 60% or less, 55% or less, 50% or less, 45% or less, 40% or less, 35% or less, 30% or less, or 25% or less of the thickness of the plate glass 20. The thickness of the cavity die 530 may be 10% or more, or 15% or more of the thickness of the plate glass 20. In particular, the thickness of the cavity die 530 may be 50% to 60% of the thickness of the plate glass 20.

A thickness of the glass spacer 510 may be 10% or more of the thickness of the plate glass 20. The thickness of the glass spacer 510 may be 15% or more, 20% or more, 25% or more, 30% or more, 35% or more, 40% or more, 45% or more, 50% or more, 55% or more, 60% or more, 65% or more, 70% or more, 75% or more, 80% or more, or 85% or more of the thickness of the plate glass 20. The thickness of the glass spacer 510 may be 90% or less, or 85% or less of the thickness of the plate glass 20. In particular, the thickness of the glass spacer 510 may be 60% to 80% of the thickness of the plate glass 20. In another example, the thickness of the glass spacer 510 may be 40% to 50% of the thickness of the plate glass 20.

The thickness of the glass spacer 510 may be 600 µm or less, 550 µm or less, 500 µm or less, 450 µm or less, 400 µm or less, 350 µm or less, 300 µm or less, 250 µm or less, 200 µm or less, 150 µm or less, 125 µm or less, 100 µm or less, 75 µm or less, or 50 µm or less. The thickness of the glass spacer 510 may be 5 µm or more, 10 µm or more, or 15 µm or more.

Applying the cavity die and the glass spacer within these ranges is advantageous for a more efficient cavity configuration.

Referring to FIG. 3, Td is a thickness between an upper face of the cavity die 530 and a lower face of the glass spacer 510. If an electrode of the cavity die protrudes from the surface of the cavity die, such protrusion thickness is excluded.

In the embodiments, Td may be 40 µm or more. Td may be 60 µm or more, 90 µm or more, 120 µm or more, 180 µm or more, 240 µm or more, 280 µm or more, 300 µm or more, 340 µm or more, 360 µm or more, 400 µm or more, or 430 µm or more. Td may be 500 µm or more or 460 µm or more. Td may be smaller than the thickness of the plate glass.

A thickness of the plate glass may be greater than 300 µm, or 400 µm or more, 500 µm or more, 600 µm or more, or 700 µm or more. The thickness of the plate glass may be 1,500 µm or less, 1,400 µm or less, 1,300 µm or less, 1,200 µm or less, 1,100 µm or less, or 1,000 µm or less.

In the embodiments, the glass core for packaging applies a glass spacer together with a cavity die, thereby transferring the stable properties of the glass of the substrate to the cavity die, improving the processability of the plate glass that is otherwise prone to breakage, and enabling electrical connection to the cavity die through a relatively simple process. As a result, a glass core for cavities is provided with improved workability and reliability.

### Packaging Substrate

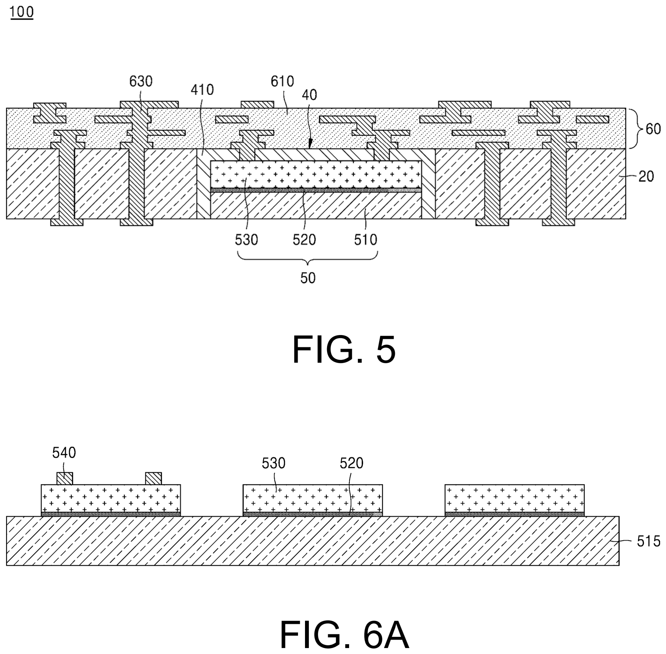

FIG. 5 is a conceptual cross-sectional view illustrating a packaging substrate according to an embodiment. FIGS. 1 to 4 are conceptual cross-sectional views illustrating glass cores for packaging, respectively. The glass cores for packaging shown in FIGS. 1 to 4 are applied to the packaging substrate of FIG. 5. With reference to FIGS. 1 to 5, the packaging substrate will be described in detail.

A packaging substrate 100 according to an embodiment comprises: a glass core for packaging 90; and an upper redistribution layer 60 disposed over the glass core for packaging 90.

Detailed descriptions of the glass core for packaging 90 are omitted to avoid redundancy.

The upper redistribution layer 60 comprises an upper electrically conductive layer 630 and an upper insulating layer 610. The upper electrically conductive layer 630 is a layer in which an electrically conductive material forms and connects in a pattern. The upper insulating layer 610 has the upper electrically conductive layer 630 disposed therein.

The upper redistribution layer 60 is disposed over the glass core for packaging, and wiring layers and blind vias are arranged in predetermined forms. The wiring layers enable signal transmission in an in-plane direction, and the blind vias enable signal transmission in an up-down (thickness) direction.

The upper redistribution layer 60 may be manufactured by a process for forming a redistribution layer as applied in the semiconductor field.

A cover layer (not shown) may further be disposed over the upper redistribution layer. The cover layer protects the upper redistribution layer and may form a structure connectable to connection electrodes or bumps. By way of example, a polyimide layer may be used for the cover layer, but the cover layer is not limited thereto.

A lower redistribution layer (not shown) comprises a lower electrically conductive layer and a lower insulating layer. The lower electrically conductive layer is a layer in which an electrically conductive material forms and connects in a pattern, and the lower insulating layer has the lower electrically conductive layer disposed therein.

The lower redistribution layer is disposed under the glass core for packaging, and wiring layers and blind vias are arranged in predetermined forms. The wiring layers enable in-plane signal transmission, and the blind vias enable signal transmission in the thickness direction.

The lower redistribution layer may be manufactured by a process for forming a redistribution layer as applied in the semiconductor field.

A solder resist layer may further be disposed under the lower redistribution layer. The solder resist layer protects the lower redistribution layer and may form a structure connectable to connection electrodes or bumps.

A semiconductor element may be disposed over the packaging substrate. Examples of the semiconductor element include computing elements and memory elements, but the semiconductor element is not limited thereto.

A lower side of the packaging substrate may be connected to a motherboard.

In the embodiments, the packaging substrate applies a glass core and simultaneously applies a glass spacer within a die block in the cavity. The glass spacer maintains advantages of the plate glass of the glass core and exhibits excellent dimensional stability. In addition, by adjusting a gap between the cavity die and the cavity space, a packaging substrate with improved performance can be provided.

### Method of Manufacturing the Glass Core for Packaging

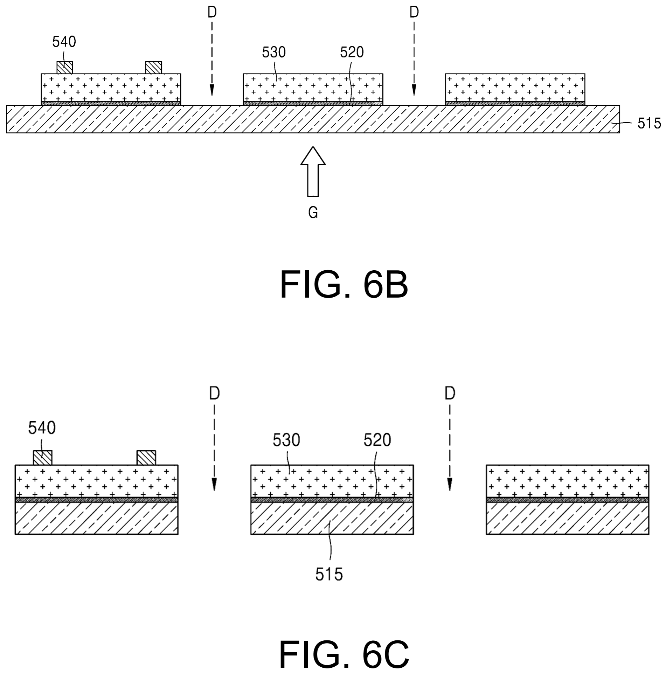

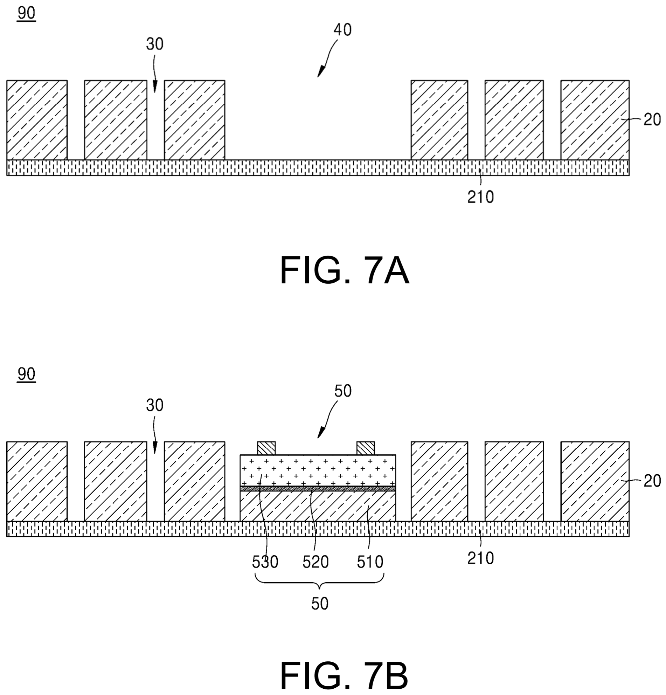

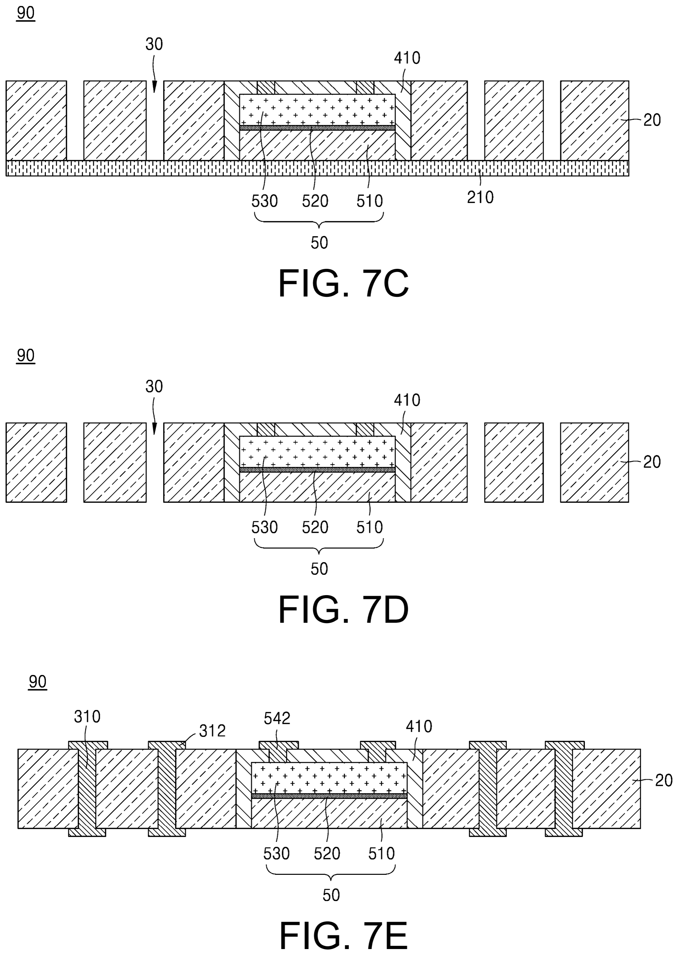

FIGS. 6A to 6C are conceptual cross-sectional views illustrating a process of manufacturing a die block according to an embodiment, and FIGS. 7A to 7E are conceptual cross-sectional views illustrating a process of manufacturing a glass core for packaging according to an embodiment. Although FIGS. 6A to 6C and FIGS. 7A to 7E exemplify the process for manufacturing the glass core for packaging of FIG. 4, glass cores for packaging of FIGS. 1 to 3 may be manufactured in a similar manner.

With reference to these drawings, a method of manufacturing a glass core for packaging 90 according to an embodiment will be described in detail.

The method comprises a placing operation; a dispensing operation; and a fixing operation.

The placing operation is an operation of disposing, on a carrier 210, plate glass in which a cavity 40 is arranged and a die block 50 to obtain an assembly.

The carrier 210 detachably fixes positions of the plate glass 20 and the die block 50. For example, a film may be used.

The carrier 210 may comprise a support layer and an adhesive layer disposed on the support layer. The adhesive layer may be one whose adhesive force changes upon irradiation with ultraviolet light.

In the assembly, the adhesive layer maintains its adhesive force to fix the positions of the plate glass and the die block, and after the dispensing operation described below, the adhesive force is weakened so that the carrier can be easily removed from the assembly.

For example, an adhesive layer whose adhesive force is weakened by ultraviolet irradiation may be used. The carrier 210 fixes the positions of the plate glass and the die block to perform required processes in one operation, and in another operation the plate glass and the die block can be separated from the weakened adhesive layer by irradiating ultraviolet light.

The dispensing operation is an operation of disposing a distribution material 410 between a cavity inner wall of the assembly and the die block 50 to prepare a fixed body.

The dispensing operation may comprise: a first process of disposing a film-shaped distribution material between components of the assembly; a second process of allowing the distribution material to be drawn into between the cavity inner wall and the die block 50 through vacuum lamination; and a third process of heat-treating the assembly at least once to induce curing of the distribution material and thereby fix the distribution material.

Detailed descriptions of the distribution material are omitted to avoid redundancy with the foregoing description.

As described above, empty spaces may be present in the through-electrodes.

In this case, the distribution material and an insulating material applied to the empty spaces of the through-electrodes may be different materials, or they may be the same material. If the same material is used, placement of the distribution material in the dispensing operation and placement of the insulating material in the empty spaces of the through-electrodes may proceed simultaneously.

The fixing operation is an operation of removing the carrier 210 from the fixed body to obtain the glass core for packaging 90.

Various methods may be applied to remove the carrier from the fixed body. For example, when using the method in which the adhesive force of the adhesive layer is weakened by ultraviolet irradiation as mentioned above, the glass core for packaging can be obtained by a relatively simple method of irradiating ultraviolet light to the fixed body and peeling off the carrier film.

The die block 50 may be prepared by a die-block manufacturing operation.

The die-block manufacturing operation comprises: a die placing process of disposing one or two or more cavity dies 530 at intervals on spacer glass 515 to prepare a placement material; and a die separating process of dicing the interval locations (indicated by symbol D in FIG. 6B) to separate the placement material and obtain the die block 50.

Dicing may be performed by a conventional method for cutting plate glass or a semiconductor element; for example, the intended cutting locations may be treated with a laser, followed by applying mechanical force to separate and then polishing the cut surfaces. However, the dicing method is not limited thereto.

The die-block manufacturing operation may further comprise a polishing operation.

The polishing operation may be performed after the die placing process.

The spacer glass 515 has a first face on which the cavity die 530 is disposed and a second face opposite to the placement face.

The polishing operation may be an operation of grinding a surface of the second face of the spacer glass 515 (indicated by symbol G in FIG. 6B).

The grinding may be performed by a method used for glass grinding or a grinding method used in semiconductor processes. For example, a CMP (Chemical Mechanical Polishing) process may be applied, but the method is not limited thereto.

The cavity die may already have electrodes formed thereon when applied in the die placing process.

Additional electrodes may be formed on the cavity die. Formation of electrodes on the cavity die may be performed by a method used for forming electrodes in a packaging substrate. Specifically, a primer layer or a sputter layer may be formed at a position where an electrode is to be formed, and a copper layer or another conductive layer may then be selectively formed thereon. Although copper is mentioned as an example, any electrically conductive layer may be applied.

Formation of the copper layer may be performed, for example, by electroplating.s

A location where the copper layer is to be formed may be prepared by etching a portion of an insulating layer.

For example, the method of manufacturing the glass core for packaging 90 may further comprise an electrode-forming operation.

The electrode-forming operation is an operation of forming electrodes in vias; specifically, it is an operation of forming through-electrodes by disposing electrically conductive layers in through-vias.

The electrode-forming operation may be performed before the placing operation or after the fixing operation. Formation of the electrodes may be carried out by copper plating, but the method is not limited thereto.

In the embodiments, use of a glass spacer when embedding a die in a cavity of the glass core can alleviate thickness differences, thereby improving workability and reliability. In addition, height differences between a die embedded in the cavity and a surface of the glass core may be reduced, enabling a redistribution layer to be formed more efficiently. Furthermore, the embodiments of the invention are useful for application in semiconductor packaging, and by employing a glass core, provides excellent insulating characteristics distinguishable from wafers and fine wiring resolution distinguishable from prepregs, thereby offering a glass core for packaging with superior performance.

Although the preferred embodiments of the present invention have been described in detail above, the scope of the present invention is not limited thereto, and various modifications and improvements made by those skilled in the art based on the basic concept defined in the following claims also fall within the scope of the present invention.

## Claims

1. A glass core for packaging comprising:
a plate glass having a first surface and a second surface facing each other;
through-vias penetrating the plate glass in a thickness direction; and
a cavity penetrating the first and second surfaces and allowing a semiconductor element to be disposed therein,
wherein the cavity provides a cavity space surrounded by a cavity inner wall,
the cavity inner wall is an inner wall surface of the plate glass connecting the first and second surfaces of the plate glass,
a die block is disposed in the cavity space,
the die block has a cavity die, which is a die disposed in the cavity, and a glass spacer stacked vertically, and
a distribution material is disposed between the cavity inner wall and the die block.

2. The glass core for packaging of claim 1,
wherein the die block further comprises a die adhesive layer as an adhesive layer, and
the die adhesive layer is disposed between the cavity die and the glass spacer.

3. The glass core for packaging of claim 1,
wherein the die block has a first face and a second face facing each other, and
one of (i) the first surface of the plate glass and the first face of the die block, or (ii) the second surface of the plate glass and the second face of the die block, is disposed substantially coplanar.

4. The glass core for packaging of claim 1,
wherein the cavity die has a first face in contact with the glass spacer and a second face opposite to the first face, and
an electrode of the cavity die is disposed on the second face of the cavity die.

5. The glass core for packaging of claim 1,
wherein a cavity redistribution line is further disposed on one face or the other face of the cavity die, and
the cavity redistribution line is a redistribution line delivering an electrical signal of the cavity die to outside the cavity.

6. The glass core for packaging of claim 1,
wherein the die block has a thickness (Td) of 40 µm or more between an upper surface of the cavity die and a lower surface of the glass spacer.

7. The glass core for packaging of claim 4,
wherein through-electrodes are disposed in the through-vias,
the through-electrodes deliver electrical signals between the first and second surfaces of the plate glass,
the through-electrodes have through-electrode pads disposed on at least one of the first and second surfaces of the plate glass,
a pad disposed at one end of the electrode of the cavity die is a cavity-die electrode pad, and
based on a surface of the through-electrode pad, a surface of the cavity-die electrode pad is disposed within a range of -100 µm to + 100 µm in a thickness direction of the glass core.

8. A method of manufacturing a glass core for packaging comprising:
a placing operation of disposing, on a carrier, plate glass in which a cavity is arranged and a die block to obtain an assembly;
a dispensing operation of disposing a distribution material between a cavity inner wall of the assembly and the die block to prepare a fixed body; and
a fixing operation of removing the carrier from the fixed body to obtain the glass core for packaging,
wherein the carrier detachably fixes positions of the plate glass and the die block,
the plate glass is a plate-shaped glass having a first surface and a second surface facing each other,
the plate glass comprises the cavity and through-vias,
the through-vias penetrate the plate glass in a thickness direction,
the cavity provides a cavity space surrounded by a cavity inner wall,
the cavity inner wall is an inner wall surface of the plate glass connecting the first and second surfaces of the plate glass,
the cavity space allows placement of a cavity die,
the cavity die is a die disposed in the cavity, and
the die block has the cavity die and a glass spacer stacked vertically.

9. The method of claim 8,
wherein the carrier comprises a support layer and an adhesive layer disposed on the support layer, and
the adhesive layer changes its adhesive force upon irradiation with ultraviolet light.

10. The method of claim 8,
wherein the die block is prepared by a die-block manufacturing operation,
and the die-block manufacturing operation comprises:
a die placing process of disposing one or two or more cavity dies at intervals on spacer glass to prepare a placement material; and
a die separating process of dicing an interval locations to separate the placement material and obtain the die block.

11. The method of claim 10,
wherein a polishing operation is performed after the die placing process,
the spacer glass has a first face on which the cavity dies are disposed and a second face opposite to the placement face, and
the polishing operation is an operation of grinding a surface of the second face of the spacer glass.

12. The method of claim 8,
wherein an electrode of the cavity die is disposed on one surface of the cavity die,
the glass spacer has a first face and a second face facing each other,
the second surface of the plate glass and the second face of the glass spacer are disposed substantially in the same plane, and
the electrode of the cavity die is disposed substantially coplanar with the first surface of the plate glass or disposed to protrude beyond the coplanar plane.

13. The method of claim 8,
wherein the dispensing operation comprises:
a first process of disposing a film-shaped distribution material between components of the assembly;
a second process of allowing the distribution material to be drawn into between the cavity inner wall and the die block through vacuum lamination; and
a third process of heat-treating the assembly at least once to induce curing of the distribution material and fix the distribution material.

14. The method of claim 13,
wherein in the placing operation, through-electrodes are disposed in a portion of the through-vias of the plate glass while remaining portions are empty spaces, and
placement of the distribution material in the dispensing operation and placement of an insulating material in the empty spaces of the through-electrodes proceed simultaneously.
